# EUROPÄISCHE PATENTSCHRIFT

(11) **EP 0 269 095 B1**
(45) Veröffentlichungstag und Bekanntmachung des Hinweises auf die Patenterteilung: **16.02.1994**
(21) Anmeldenummer: 87117415.7
(22) Anmeldetag: 25.11.1987
(51) Int. Cl.: H01L 23/532, H01L 21/60, H01L 21/90

(54) **Integrierte Halbleiterschaltung mit mindestens zwei aus Aluminium oder einer Aluminium-Verbindung bestehenden Metallisierungsebenen sowie Verfahren zu ihrer Herstellung**
Integrated semiconductor circuit with at least two planes made of aluminium or aluminium compound and method of manufacturing the same
Circuit intégré à semi-conducteur ayant au moins deux plans métallisés en aluminium ou en alliage d'aluminium ainsi que son procédé de fabrication

(30) Priorität: 28.11.1986 DE 3640656
(43) Veröffentlichungstag der Anmeldung: 01.06.1988
(73) Patentinhaber: SIEMENS AKTIENGESELLSCHAFT, 80333 München (DE)
(72) Erfinder: Kücher, Peter, Dipl.-Phys., D-8400 Regensburg (DE)

(56) Entgegenhaltungen:
- EP-A- 0 127 281
- EP-A- 0 211 318
- US-A- 4 566 026
- INTERNATIONAL ELECTRON DEVICES MEETING, PROCEEDINGS 1983 Seiten 550-553; T. MORIYA et al.: "A planar metallization process - its application to tri-level aluminium interconnection"
- PROCEEDINGS OF THE SECOND INTERNATIONAL IEEE VLSI MULTILEVEL INTERCONNECTION CONFERENCE 25-26. Juni 1985, Seiten 169-176, New York, USA; S. CHEN et al.: "The use of TiN produced by rapid thermal annealing in the first level metallization for VLSI devices"
- PROCEEDINGS OF THE THIRD INTERNATIONAL IEEE VLSI MULTILEVEL INTERCONNECTION CONFERENCE 9-10. Juni 1986, Seiten 443-449, New York, USA; G. HIGELIN et al.: "A contact filling process with CVD-tungsten for multilevel metallization systems"
- IBM TECHNICAL DISCLOSURE BULLETIN; Bd. 24, Nr. 12, Mai 1982, Seite 6272
- Der Artikel von S. CHEN et al. ist erschienen in Proceedings of the 4th International IEEE VLSI Multilevel Interconnection Conference, June 15-16, 1987, S. 169-176

## Beschreibung

Die Erfindung betrifft eine integrierte Halbleiterschaltung mit einem aus Silizium bestehenden Substrat, in dem und auf dem die die Schaltung bildenden Elemente erzeugt sind mit einer ersten, auf dem Substrat angeordneten Isolationsschicht, die mit Kontaktlöchern versehen ist, und mit mindestens zwei aus Aluminium oder einer Aluminium-Verbindung bestehenden, durch eine weitere mit Kontaktlöchern versehene Isolationsschicht getrennten Metallisierungsebene, welche unter Verwendung von aus Wolfram bestehenden Kontaktlochfüllern unter sich und mit den zu kontakierenden Bereichen im und auf dem Siliziumsubstrat verbunden sind, wobei auf jeder Metallisierungsebene eine Metallsilizidschicht als Deckschicht angeordnet ist.

Aufgabe der Erfindung ist es, ein Mehrlagenmetallisierungssystem für integrierte Halbleiterschaltungen anzugeben, welches folgende Anforderungen erfüllt:
1. Es sollen Verdrahtungen mit Leiterbahnabständen im sub-µm-Bereich möglich sein.
2. Es soll eine möglichst hohe Planarisierung für die Metallisierung und damit eine Platzersparnis für das Einzelelement erreicht werden.
3. Die elektrische und die mechanische Stabilität der Verdrahtung soll gewährleistet sein, das heißt, die Aluminiumleiterbahnebenen sollen eine hohe Elektromigrationsbeständigkeit aufweisen; in den Schichten sollen keine thermischen Spannungen auftreten und keine Lunker und Korrosionen. Kurzschlüsse sollen vermieden werden.

Bei der fortschreitenden Miniaturisierung von Halbleiterbauelementen treten bereits Strukturen im Bereich von 1 µm und darunter auf. Um die sehr kleinen aktiven Bereiche auf dem Halbleitersubstrat elektrisch ansteuern zu können, müssen diese mit metallischen Leitbahnen verbunden werden. Damit dieser Kontakt nur an definierten Stellen stattfindet, ist die Leitbahn durch eine Isolationsschicht, zum Beispiel aus SiO₂ bestehend, vom Halbleitersubstrat getrennt. Die Verbindung zu den aktiven Bereichen des Halbleitersubstrats findet über Kontaktlöcher statt, die in die Isolationsschicht eingeätzt werden.

Analoge Verhältnisse herrschen auch bei höchstintegrierten Halbleiterschaltungen, bei denen zwei und mehr Leitbahnebenen für die elektrische Versorgung der sehr dicht gepackten aktiven Bereiche notwendig sind. Auch in diesem Fall muß ein elektrischer Kontakt durch sehr kleine Löcher (sogenannte via holes) zwischen den verschiedenen Leitbahnebenen hergestellt werden.

Da aufgrund von schaltungstechnischen Überlegungen (zum Beispiel parasitäre Kapazitäten) die Isolationsschicht eine Mindestdicke von 0,7 bis 1,5 µm besitzen muß, treten bei den Kontaktlöchern bzw. via holes Tiefen/Durchmesser-Verhältnisse von größer/gleich 1 auf. Bei diesen sehr kleinen und tiefen Kontaktlöchern nimmt die Schichtdicke der Leitbahnen an den Flanken des Kontaktloches sehr stark ab (55 bis 80 % Abnahme), wenn das Leitbahnmaterial zum Beispiel Aluminiumlegierungen : Aluminium-Silizium (1 %), wie bisher üblich durch Kathodenzerstäubung (Sputtern) aufgebracht wird. Da die Leitbahnen mit extrem hohen Stromdichten belastet sind (zum Beispiel 1 x 10⁶ A/cm²), bewirkt eine jede Querschnittsverengung einen lokalen Temperaturanstieg, der an den Grenzflächen zwischen den verschiedenen Materialien im Kontakt einen unerwünschten Materialtransport (Diffusion, Reaktion) beschleunigt. Dies kann auch bis zum Durchbrennen einer Leitbahn führen.

Ein weiteres Problem besteht darin, daß sich in den Kontaktlöchern nach der Beschichtung zum Beispiel mit Aluminium-Silizium Hohlräume ausbilden können. Wird nun daran anschließend eine Isolationsschicht, zum Beispiel als Unterlage für eine weitere Aluminium-Silizium-Leitbahnebene abgeschieden, so ist es praktisch nicht möglich, den im Kontaktloch befindlichen Hohlraum vollständig aufzufüllen. Da sich bei weiteren Fertigungsschritten in diesem Hohlraum zum Teil reaktive oder korrosive Medien ansammeln können, ist es für zuverlässige Bauelemente notwendig, ein Kontaktloch- bzw. via-hole-Metallisierungsschema anzugeben, bei dem eine vollständige Auffüllung stattfindet.

Aus dem Stand der Technik sind zahlreiche Verfahren bekannt, die einzelne, der hier aufgestellten Forderungen erfüllen. Ein wesentliches Problem ist die Auffüllung der Kontaktlöcher und die Verbindung zu den Metallisierungsebenen.

In der europäischen Patentanmeldung Nr. 86 11 00 76.6 (EP-A-0 211 318) wird zum Beispiel vorgeschlagen, Kontaktlöcher in Isolationsschichten oder sogenannte via holes zu tiefer gelegenen Metallisierungsebenen dadurch vollständig ohne Hohlräume mit elektrisch leitendem Material aufzufüllen, daß zunächst eine ganzflächige Beschichtung mit einem Metallsilizid durch Abscheidung aus der Gasphase durchgeführt wird, dann die Silizidschicht auf der horizontalen Oberfläche des Siliziumsubstrats wieder entfernt wird und anschließend das Kontaktloch mit metallisch leitendem Material durch selektive Abscheidung aus der Gasphase gefüllt wird. Dabei werden hochschmelzende Metalle (sogenannte refractory metals) und deren Silizide verwendet.

Ein ähnliches Kontaktlochfüllverfahren wird in der europäischen Patentanmeldung Nr. 86 10 28 21.5 (EP-A-0 199 030) vorgeschlagen, wobei anstelle der Silizide und hochschmelzenden Metalle Aluminium verwendet wird, welches durch Niederdruckgasphasenabscheidung (LPCVD) ganzflächig abgeschieden und bis auf Kontaktlochhöhe zurückgeätzt wird.

Eine integrierte Halbleiterschaltung mit einer aus Aluminium oder einer Aluminium-Verbindung bestehenden äußeren Leiterbahnebene, bei der eine Metallsilizidzwischenschicht aus Tantaldisilizid zur Verbesserung der Strombelastung im Kontaktloch abgeschieden worden ist, ist aus der europäischen Patentanmeldung EP-A-0 132 720 bekannt.

Schließlich ist in der deutschen Patentanmeldung DE-A-36 15 893.3 auch bereits vorgeschlagen worden, zum Auffüllen von Kontaktlöchern in Isolationsschichten von integrierten Halbleiterschaltungen Wolfram zu verwenden. Aufgrund der guten Kantenbedeckung des CVD-Verfahrens wächst die Schicht im Kontaktloch von allen Seiten etwa gleich schnell und füllt das Kontaktloch auf.

In dem Artikel von T. Moriya et al. in Proceedings of IEDM 1983, Seiten 550 bis 553, ist eine Mehrlagenverdrahtung für integrierte Schaltungen beschrieben, bei welcher die Metallisierungsebenen aus AlSi mit einer Molybdänsilizid-Deckschicht bestehen und untereinander und mit dem Substrat über selektiv mit Wolfram aufgefüllte Kontaktlöcher verbunden sind. Die Deckschicht dient dabei ausschließlich zur Verringerung des Übergangswiderstandes zur überliegenden Wolfram-Kontaktloch-Auffüllung und zur Erhöhung der Abscheiderate bei der selektiven Wolfram-Abscheidung. Eine Barriere- oder Bekeimungsschicht unter dem Aluminium ist an keiner Stelle vorgesehen.

Aus der Veröffentlichung von G. Higelin et al. in Proceedings of the third International IEEE VLSI Multilevel Interconnection Conference 1986, Seiten 443 bis 449, ist bekannt, zur Verringerung des Übergangswiderstandes im Kontaktloch eine Titan-Zwischenschicht vorzusehen.

In der Druckschrift US-A-45 66 026 ist ein Metallisierungssystem beschrieben, das aus Aluminium oder einer Aluminiumlegierung mit einer unterliegenden TiN/TiWN-Doppelschicht besteht und für eine Mehrlagenverdrahtung geeignet ist. In den das Substrat kontaktierenden Kontaktlöchern dient die Doppelschicht zur Verhinderung von Spiking-Effekten und Ionen-Kontamination. An allen übrigen Stellen - also auf einem Dielektrikum oder einer unterliegenden Metallisierungsebene - dient die Doppelschicht als Ätzstop-Schicht bei der Strukturierung der auf ihr aufgebrachten Aluminiumschicht.

Die Gefahr der Elektromigration wird durch ein solches Metallisierungssystem nicht verringert.

Die Erfindung geht von diesem Stand der Technik aus und verwendet zusätzlich zur Erzielung niederohmiger Leiterbahnen aus Aluminium mit hoher Strombelastbarkeit der Kontakte ein Metallmehrlagenschichtsystem. Sie ist bei einer integrierten Halbleiterschaltung gemäß dem Oberbegriff des Anspruchs 1 **gekennzeichnet durch**
a) eine erste Metallzwischenschicht aus Wolframsilizid (WSiₓ) oder Titan/Wolfram, Titan/Wolfram-Nitrid oder Titan-Nitrid, die zwischen den untersten Kontaktlochfüllern und den zu kontaktierenden Siliziumbereichen angeordnet ist, und
b) eine als Bekeimungsschicht für die Aluminiummetallisierung dienende, jeweils unter einer Metallisierungsebene angeordnete Zwischenschicht, wobei die Zwischenschicht aus einer Ti/TiN-Doppelschicht mit definiertem Gefüge besteht, so daß die darüberliegende Aluminiummetallisierungsebene zur Erhöhung der Elektromigrationsbeständigkeit eine starke 〈111〉- Textur mit homogener Kristallitgrößenverteilung aufweist.

Dabei liegt es im Rahmen der Erfindung, daß die Deckschichten aus Molybdänsilizid (MoSi₂) bestehen.

Weitere Ausgestaltungen der Erfindung sowie insbesondere Verfahren zu ihrer Realisierung ergeben sich aus den Unteransprüchen.

Gegenüber den zum Stand der Technik genannten Metallisierungssystemen weist die erfindungsgemäße Kombination entscheidende Vorteile auf:
1. Die Verwendung von Aluminium in der Mikroelektronik bereitet keine Schwierigkeiten mehr. Durch die Verwendung der Bekeimungsschicht, vorzugsweise von Titan/Titannitrid, vor dem Aufbringen der Aluminiumleitbahnebene wird die Elektromigrationsbeständigkeit erhöht. Kristallitstruktur, Textur und Kristallitgrößenverteilung des Aluminium wird verbessert. Die aus Titan/Titannitrid bestehende Zwischenschicht führt zu einem Spannungsabbau zwischen Wolfram und Aluminium und damit zu einer sicheren Wolfram-Aluminium-Kontaktierung. Korrosionsprobleme treten nicht auf.
2. Kontaktlöcher mit großem Aspektverhältnis (größer 1) und kleinem Kontaktlochdurchmesser (kleiner 1 µm) weisen durch die Verwendung von Wolframabscheidungen eine gute Kantenbedeckung auf. Dadurch sind hohe Stromdichten möglich. Außerdem bietet Wolfram den Vorteil einer guten Diffusionsbarriere zu monokristallinem oder polykristallinem Silizium mit niedrigem Übergangswiderstand.
3. Eine niederohmige via-hole-Metallisierung wird durch die Möglichkeit der selektiven Wolframabscheidung erreicht. Dadurch ist auch eine Reduzierung des Aspektverhältnisses (Verbesserung der Aluminiumkantenbedeckung mit Planarisierung) verbunden.
4. Durch die Verwendung der Deckschicht über der Aluminiummetallisierungsebene aus vorzugsweise Molybdänsilizid wird das Hillock-Wachstum durch die Bildung einer aluminiumreichen Aluminium/Silizium/Molybdän- oder Aluminium/Molybdän-Verbindung unterdrückt und Spannungen zwischen dem Isolationsschichtmaterial und der Aluminiummetallisierung ausgeglichen. Es können höhere Prozeßtemperaturen (größer 450°C) bei der (selektiven) Wolframabscheidung oder bei Folgeprozessen in Kauf genommen werden, ohne daß durch eine Rekristallisation eine Textur- und Gefügeänderung in der Aluminiumschicht auftritt. Zur Bildung von Hillocks kommt es durch Druckspannungen in den Aluminium-Schichten oder an hot spots (lokale hohe Temperaturgradienten). Kann Aluminium mit dem Deckschichtmaterial reagieren so kommt es zu einem Spannungsabbau und die Reaktion verhindert das Durchstoßen der Deckschicht (Vermeidung von Whisker). Die Elektromigrationsbeständigkeit wird nicht verringert; ein stabiles Aluminiumgefüge wird auch bei Temperaturen über 450°C gewährleistet.
5. Das Metallisierungsschema läßt sich für mehrere Metallisierungsebenen fortsetzen und ist deshalb für die Verdrahtung höchstintegrierter Halbleiterschaltungen sehr gut geeignet.

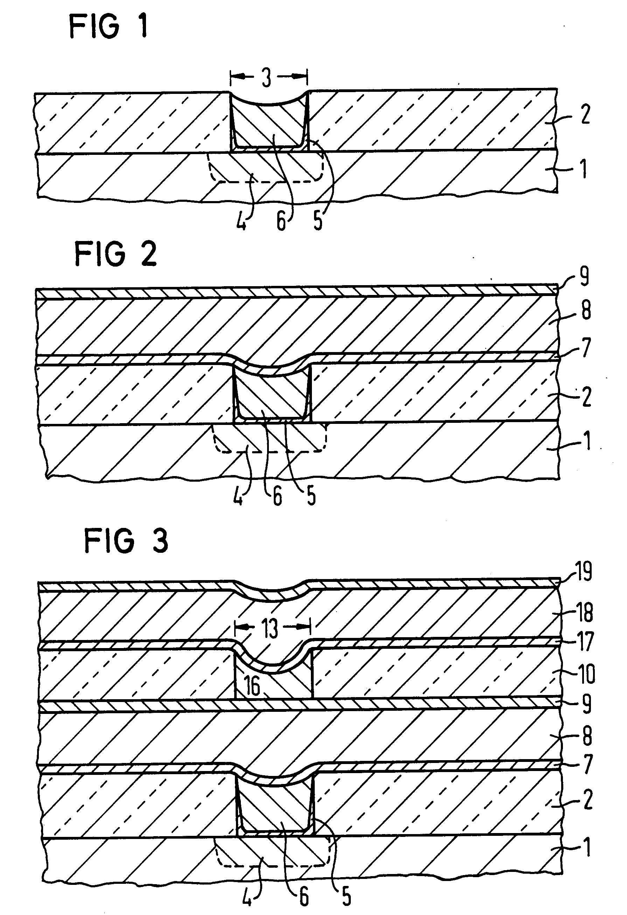

Im folgenden wird anhand eines Ausführungsbeispiels und der Figuren 1 bis 4, welche im Schnittbild die wesentlichen Verfahrensschritte zur Herstellung des erfindungsgemäßen Metallisierungssystems darstellen, die Erfindung noch näher beschrieben. Dabei gelten in allen Figuren für gleiche Teile gleiche Bezugszeichen.

Figur 1: Auf das mit dem Bezugszeichen 1 gekennzeichnete Substrat, zum Beispiel die Oberfläche einer Siliziumkristallscheibe als zu kontaktierende Oberfläche, wird eine als erste Isolationsschicht dienende SiO₂-Schicht 2 aufgebracht, in die das Kontaktloch 3 mit einem Durchmesser von ca. 0,8 µm im Bereich des diffundierten Bereiches 4 im Siliziumsubstrat 1 eingeätzt worden ist. Auf diese Anordnung 1, 2, 3, 4 wird nach kurzem Überätzen in Flußsäure nun ganzflächig eine Doppelschicht 5, 6, bestehend aus einer 10 nm dicken Wolfram-Silizium-Legierung (1:2,5) und einer 800 nm dicken reinen Wolframschicht 6 durch thermische Zersetzung von Wolframhexafluorid mit Wasserstoff als Reaktionsgas bei 450°C in einem Kaltwandreaktor bei niedrigem Druck aufgebracht. Die Zwischenschicht 5 aus Wolframsilizid dient als Diffusionsbarriere bei späteren Temperaturschritten. Statt einer Wolframsilizidschicht (5) kann auch eine Schicht aus Titan/Wolfram (Ti/W), Titan/Wolfram-Nitrid (Ti/W:N) oder Titan-Titannitrid (Ti/TiN) verwendet werden, die als Diffusionsbarriere für Si bei der späteren Wolframabscheidung und nachfolgenden Temperaturschritten geeignet ist und dabei einen niederohmigen Kontakt zum diffundierten Bereich gewährleistet.Die auf der Substratoberfläche 1 vorhandene Wolframsilizid- und Wolframschicht (5, 6) wird zurückgeätzt bis nur noch das Kontaktloch (3) mit Wolfram (6) gefüllt bleibt.

Figur 2: Als nächster Schritt erfolgt die Abscheidung einer aus der Kombination Titan (20 nm)/Titannitrid (100 nm) bestehenden Bekeimungsschicht 7 für das nachfolgende Aufbringen der überwiegend aus Aluminium (zum Beispiel Aluminium/Silizium oder Aluminium/Silizium/Titan) bestehenden ersten Metallisierungsebene 8. Wie schon ausgeführt, zeigt Aluminium auf Titan/Titannitrid eine starke 〈111〉 Textur und sehr homogene Kristallitgrößenverteilung bei geeigneten Herstellungsparametern mit Kathodenzerstäubung oder Aufdampfen. (hohe Aufwachsrate 20 nm/sec, niedriger Restgasanteil kleiner 1 . 10⁻⁶ Pa).

Die Verbesserung der Elektromigrationseigenschaften von zum Beispiel einer Aluminium/Kupfer-Legierung beruht nicht auf dem Einbau von Zwischenschichten, sondern wesentlich auf der dadurch erreichten Kristallitstruktur, Textur und Kristallitgrößenverteilung des Aluminium. Weist die Bekeimungsschicht aus vorzugsweise Ti/TiN eine starke Textur auf, so übertragt sich diese auch auf die Aluminiumschicht. Die Korngrößenverteilung des Aluminiums wird dabei durch das Gefüge der Bekeimungsschicht bestimmt und kann somit gezielt eingestellt werden. Die Titan/Titannitrid-Schicht 7 führt zu dem zu einem Spannungsabbau zwischen Wolfram (6) und Aluminium (8) (thermischer Ausdehnungskoeffizient °C für Aluminium = 25 x 10⁻⁶, für Wolfram = 4,5 x 10⁻⁶, für Titan = 8,5 x 10⁻⁶) und damit zur Hillock-Unterdrückung und zu einer sicheren Aluminium/Wolfram-Kontaktierung. Nähere Einzelheiten darüber sind aus dem Journ. of Vac. Sci. Technol. A2 (2) April - June 1984, auf den Seiten 241/242 aus einem Bericht von P. S. Ho und T. Kwok zu entnehmen. Als weiteren Vorteil bietet die Ti/TiN-Schicht eine definierte Bekeimungsschicht für Al im Gegensatz zu der nach der Wolfram-Rückätzung bzw. selektiven Wolfram-Abscheidung mit Rückständen behafteten SiO₂-Oberfläche.

Vor der Herstellung der zweiten Isolationsschicht (10) und der zweiten Metallisierungsebene (18, siehe Figur 3) wird auf die erste Metallisierungsebene 8 eine Deckschicht 9 aus zum Beispiel Molybdänsilizid in einer Schichtdicke von 100 nm aufgebracht. Die Deckschicht 9 kann sowohl von einem Sintertarget als auch von einem zusammengesetzten Target (aus Teilen von Silizium und Molybdän) durch Kathodenzerstäubung aufgebracht werden.

Die Dreifachschicht (7, 8, 9) wird im Leiterbahnmuster strukturiert; dieser Vorgang ist, da erfindungsunwesentlich, in den Figuren nicht dargestellt.

Figur 3: Nach der Abscheidung der zweiten Isolationsschicht (SiOₓ) 10 und dem Öffnen des via hole 13 zum Beispiel durch reaktives Ionenätzen in einem Freon-Sauerstoff (CF₄/O₂)-Gemisch erfolgt eine selektive Wolframabscheidung 16 im via hole 13 mit Wolframhexafluorid (WF₆). Wenn sich ein flüchtiges oder kein Metallfluorid bildet (dies ist abhängig von Prozeßtemperatur und Druck), ist es möglich, im via hole 13 selektiv Wolfram abzuscheiden. Zum Beispiel werden folgende Parameter eingestellt:
300°C/Flußverhältnis H₂/WF₆ = 1.53,
Druck 0,42 Torr (Anicon Heißwand CVD-Raktiv)
1. Reaktion zum Beispiel bei TiSi₂

   WF₆ + 3/2 Ti → W + 3/2 TiF₄
2. Auffüllung WF₆ + 3 H₂ → W + 6HF
Damit wird sowohl eine Reduzierung des Aspektverhältnisses als auch eine niederohmige via-hole-Metallisierung 16 erreicht. Die darauf abgeschiedene zweite Titan/Titannitrid-Schicht 17 wird wie bei Figur 2 beschrieben erzeugt; desgleichen auch die zweite Metallisierungsebene 18. Anschließend wird eine zweite Deckschicht 19, zum Beispiel aus Molybdänsilizid auf der zweiten Metallisierungsebene 18 wie bei Figur 2 beschrieben, aufgebracht und strukturiert. Die Deckschichten 9 und 19, zum Beispiel aus Molybdänsilizid, dienen unter anderem auch zur Hillock-Unterdrückung, indem sie aluminiumreiche Aluminium/Silizium/Molybdän- oder Aluminium/Molybdän-Verbindungen bilden. Dabei werden Spannungen zwischen den Isolationsschichten (2, 10) und den Metallisierungsebenen (8, 18) ausgeglichen.

Bei Verwendung von durch Kathodenzerstäubung mit Vorspannung hergestellten Si0ₓ-Dielektrika wird eine Schädigung des Aluminiums durch Rücksputtereffekt zu Beginn der Abscheidung vermieden, da die Rücksputterrate des Silizids geringer ist als die von Aluminium.

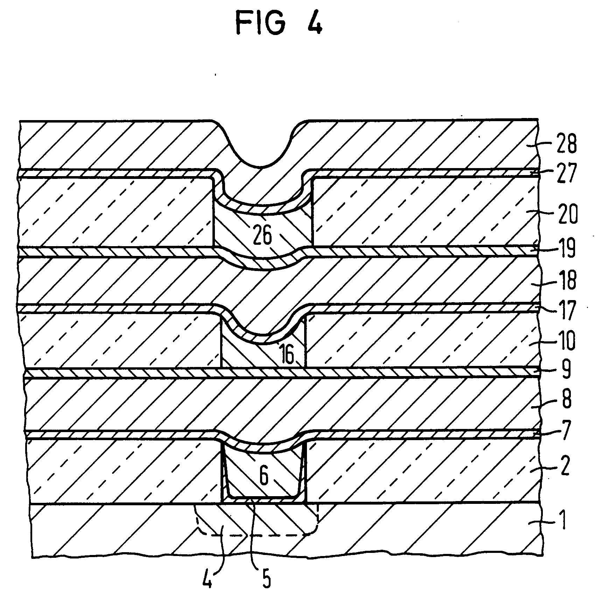

Figur 4 zeigt wie das erfindungsgemäße Metallisierungsschema für mehrere Metallisierungsebenen (hier drei Ebenen) anwendbar ist. Mit dem Bezugszeichen 20 ist die dritte Isolationsschicht (SiOₓ), mit 26 die zweite via-hole-Auffüllung mit Wolfram, mit 27 die dritte, aus Titan/Titannitrid bestehende Bekeimungsschicht und mit 28 die dritte Metallisierungsebene bezeichnet.

## Patentansprüche

1. Integrierte Halbleiterschaltung mit einem aus Silizium bestehenden Substrat (1), in dem und auf dem die die Schaltung bildenden Elemente erzeugt sind mit einer ersten, auf dem Substrat angeordneten Isolationsschicht (2), die mit Kontaktlöchern (3) versehen ist, und mit mindestens zwei aus Aluminium oder einer Aluminium-Verbindung bestehenden, durch eine weitere mit Kontaktlöchern (13) versehene Isolationsschicht (10, 20) getrennten Metallisierungsebenen (8, 18, 28), welche unter Verwendung von aus Wolfram bestehenden Kontaktlochfüllern (6, 16, 26) unter sich und mit den zu kontaktierenden Bereichen (4) im und auf dem Siliziumsubstrat (1) verbunden sind, wobei auf jeder Metallisierungsebene (8, 18, 28) eine Metallsilizidzwischenschicht (9, 19) als Deckschicht angeordnet ist, **gekennzeichnet durch**
a) eine erste Metallzwischenschicht (5) aus Wolframsilizid (WSiₓ) oder Titan/Wolfram, Titan/Wolfram-Nitrid oder Titan-Nitrid, die zwischen den untersten Kontaktlochfüllern (6) und den zu kontaktierenden Substratbereichen (4) angeordnet ist und
b) eine als Bekeimungsschicht für die Aluminiummetallisierung dienende, jeweils unter einer Metallisierungsebene angeordnete Zwischenschicht (7, 17, 27), wobei die Zwischenschicht (7, 17, 29) aus einer Ti/TiN-Doppelschicht mit definiertem Gefüge besteht, so daß die darüberliegende Aluminiummetallisierungsebene (8, 18, 28) zur Erhöhung der Elektromigrationsbeständigkeit eine starke 〈111〉-Textur mit homogener Kristallitgrößenverteilung aufweist.

2. Integrierte Halbleiterschaltung nach Anspruch 1, **dadurch gekennzeichnet,** daß die Zwischenschicht (7, 17, 27) aus einer Titansehicht im Schichtdickenbereich von 10 bis 30 nm und aus einer Titannitridschicht im Schichtdickenbereich von 50 bis 150 nm besteht.

3. Integrierte Halbleiterschaltung nach Anspruch 1 oder 2, **dadurch gekennzeichnet,** daß die Deckschichten (9, 19) aus Molybdänsilizid (MoSi₂) bestehen.

4. Integrierte Halbleiterschaltung nach Anspruch 3, **dadurch gekennzeichnet** daß die Molybdänsilizidschichten (9, 19) eine Schichtdicke im Bereich von 50 bis 200 nm aufweisen.

5. Integrierte Halbleiterschaltung nach einer der Ansprüche 1 bis 4, **dadurch gekennzeichnet** daß die Schichtdicke der ersten, aus Wolframsilizid (WSiₓ) oder Titan/Wolfram, Titan/Wolfram-Nitrid oder Titan-Nitrid bestehenden Zwischenschichten (5) im Bereich von 5 bis 30 nm liegt.

6. Verfahren zum Herstellen einer integrierten Halbleiterschaltung mit einem Mehrlagensystem aus mindestens zwei Metallisierungsebenen nach einem der Ansprüche 1 bis 5, das die folgenden Verfahrensschritte umfaßt:
a) ganzflächige Beschichtung des mit den Kontaktlöchern (3) in der ersten Isolationsschicht (2) versehenen Halbleitersubstrats (1) mit einer als Bekeimungs- und Barrierenschicht dienenden ersten Zwischenschicht (5) aus Wolframsilizid oder einer Verbindung aus Titan/Wolfram, Titan/Wolfram-Nitrid oder Titan-Nitrid und Auffüllen der Kontaktlöcher (3) mit Wolfram (6) durch Niederdruck-Gasphasenabscheidung (LPCVD),
b) Entfernen der Wolfram/Wolframsilizidschicht an den horizontalen Flächen des Substrats (1) bis nur noch die Kontaktlöcher (3) mit Wolfram (6) gefüllt sind,
c) ganzflächige Abscheidung zunächst einer Titan-, dann einer Titannitridschicht durch Aufdampfen und/oder Kathodenzerstäuber als Bekeimungsschicht (7),
d) Aufbringen der ersten Metallisierungsebene (8) aus Aluminium oder einer Aluminiumverbindung durch Aufdampfen oder Kathodenzerstäubung,
e) Aufbringen einer aus einem Metallsilizid bestehenden Deckschicht (9) auf die erste Metallisierungsebene (8) durch Kathodenzerstäubung,
f) Strukturierung der ersten Metallisierungsebene (8) mit der Deckschicht (9) aus Metallsilizid und der Bekeimungsschicht (7) aus Titan/Titannitrid,
g) Abscheidung der zweiten Isolationsschicht (10) und Einbringen von Kontaktlöchern (13) (via holes) in diese,
h) Auffüllen der Kontaktlöcher (13) mit Wolfram (16) durch selektive Abscheidung von Wolfram aus der Gasphase unter Verwendung von Wolframhexafluorid,
i) Abscheidung einer weiteren Schichtkombination (17) aus Titan/Titannitrid wie bei Vefahrensschritt c) und
j) Erzeugen der zweiten Metallisierungsebene (18) aus Aluminium oder einer Aluminiumverbindung und der Deckschicht (19) aus einem Metallsilizid wie bei den Verfahrensschritten d) und e).

7. Verfahren nach Anspruch 6, **dadurch gekennzeichnet,** daß anstelle der Verfahrensschritte a) und b) die Wolframsilizid/Wolframschicht (5, 6) durch selektive Abscheidung aus der Gasphase im Kontaktloch (3) abgeschieden wird.

8. Verfahren nach Anspruch 6, **dadurch gekennzeichnet,** daß die erste Zwischenschicht (5) im Kontaktloch durch Abscheidung aus der Gasphase bei Wolframsilizid oder durch Abscheidung durch Kathodenzerstäubung bei Titan/Wolfram, Titan/Wolfram/Nitrid oder Titan/Nitrid gebildet wird.

9. Verfahren nach einem der Ansprüche 6 bis 8, **dadurch gekennzeichnet,** daß die aus einem Metallsilizid, vorzugsweise aus Molybdänsilizid, bestehenden Deckschichten (9, 19) und die aus Titan/Titannitrid bestehenden Bekeimungsschichten (7, 17, 27) durch Kathodenzerstäubung erzeugt werden.

10. Verfahren nach einem der Ansprüche 6 bis 9, **dadurch gekennzeichnet,** daß die Metallisierungsebenen (8, 18, 28) aus Aluminium oder der Verbindung Aluminium/Silizium, Aluminium/Kupfer, Aluminium/Kupfer/Silizium oder Aluminium/Titan bestehen und durch Kathodenzerstäubung oder Aufdampfen erzeugt werden.

11. Verfahren nach einem der Ansprüche 6 bis 10, **dadurch gekennzeichnet,** daß die Deckschichten (9, 19) aus Molybdänsilizid bestehen und daß für die Zwischenschichten (5, 7, 17, 9, 19) folgende Schichtdicken eingestellt werden:
| | |
|---|---|
| Wolframsilizidschicht (WSiₓ) | 5 bis 30 nm, |
| Titanschicht (Ti) | 10 bis 30 nm, |
| Titannitridschicht (TiN) | 50 bis 150 nm, |
| Molybdänsilizidschicht (MoSi₂) | 100 nm. |

12. Verfahren nach einem der Ansprüche 6 bis 11, **dadurch gekennzeichnet,** daß die Isolationsschichten (2, 10, 20) zwischen den Metallisierungsebenen (8, 18, 28) aus SiOₓ bestehen und durch Kathodenzerstäubung hergestellt werden.

13. Verfahren nach einem der Ansprüche 6 bis 12, **dadurch gekennzeichnet,** daß die Prozeßfolge für mehrere Metallisierungsebenen (8, 18, 28) beliebig oft wiederholt wird.

## Claims

1. Integrated semiconductor circuit having a substrate (1) which comprises silicon and in which and on which the elements forming the circuit are created, having a first insulating layer (2) which is disposed on the substrate and is provided with contact vias (3), and having at least two metallization levels (8, 18, 28) which comprise aluminium or an aluminium compound and are separated by a further insulating layer (10, 20) provided with contact vias (13) and which are connected to one another and to the regions (4), to be contacted, in and on the silicon substrate (1) using contact via fillers (6, 16, 26) comprising tungsten, a metal silicide interlayer (9, 19) being disposed as covering layer on each metallization level (8, 18, 28), characterized by
a) a first metal interlayer (5) composed of tungsten silicide (WSiₓ) or titanium/tungsten, titanium/tungsten nitride or titanium nitride which is disposed between the lowermost contact via fillers (6) and the substrate regions (4) to be contacted, and
b) an interlayer (7, 17, 27) which serves as nucleation layer for the aluminium metallization and is disposed in each case beneath a metallization level, the interlayer (7, 17, 27) comprising a Ti/TiN double layer having a defined microstructure, with the result that, to increase the electromigration resistance, the aluminium metallization level (8, 18, 28) situated on top of the interlayer has a strong 〈111〉 preferred orientation with homogeneous crystallite-size distribution.

2. Integrated semiconductor circuit according to Claim 1, characterized in that the interlayer (7, 17, 27) comprises a titanium layer in the layer-thickness range from 10 to 30 nm and a titanium nitride layer in the layer-thickness range from 50 to 150 nm.

3. Integrated semiconductor circuit according to Claim 1 or 2, characterized in that the covering layers (9, 19) comprise molybdenum silicide (MoSi₂).

4. Integrated semiconductor circuit according to Claim 3, characterized in that the molybdenum silicide layers (9, 19) have a layer thickness in the range from 50 to 200 nm.

5. Integrated semiconductor circuit according to one of Claims 1 to 4, characterized in that the layer thickness of the first interlayers (5), which comprise tungsten silicide (WSiₓ) or titanium/tungsten, titanium/tungsten nitride or titanium nitride is in the range from 5 to 30 nm.

6. Process for producing an integrated semiconductor circuit having a multilayer system comprising at least two metallization levels according to any one of Claims 1 to 5, which process comprises the following process steps:
a) surface-wide coating of the semiconductor substrate (1), which is provided with the contact vias (3) in the first insulating layer (2), with a first interlayer (5), which serves as nucleation and barrier layer and which is composed of tungsten silicide or a compound of titanium/tungsten, titanium/tungsten nitride or titanium nitride, and filling of the contact vias (3) with tungsten (6) by low-pressure gas-phase deposition (LPCVD),
b) removal of the tungsten/tungsten silicide layer on the horizontal areas of the substrate (1) until only the contact vias (3) are filled with tungsten (6),
c) surface-wide deposition first of a titanium layer, then a titanium nitride layer by vapour deposition and/or cathode sputtering as nucleation layer (7),
d) application of the first metallization level (8) composed of aluminium or an aluminium compound by vapour deposition or cathode sputtering,
e) application of a covering layer (9), comprising a metal silicide, on the first metallization level (8) by cathode sputtering,
f) patterning of the first metallization level (8) having the covering layer (9) composed of metal silicide and the nucleation layer (7) composed of titanium/titanium nitride,
g) deposition of the second insulating layer (10) and introduction of contact vias (13) (via holes) into the latter,
h) filling of the contact vias (13) with tungsten (16) by selective deposition of tungsten from the gas phase using tungsten hexafluoride,
i) deposition of a further layer combination (17) composed of titanium/titanium nitride as in process step c), and
j) creation of the second metallization level (18) composed of aluminium or of an aluminium compound and the covering layer (19) composed of a metal silicide as in the process steps d) and e).

7. Process according to Claim 6, characterized in that, instead of the process steps a) and b), the tungsten silicide/tungsten layer (5, 6) is deposited in the contact via (3) by selective deposition from the gas phase.

8. Process according to Claim 6, characterized in that the first interlayer (5) is formed in the contact via by deposition from the gas phase in the case of tungsten silicide or by deposition by cathode sputtering in the case of titanium/tungsten, titanium/tungsten/nitride or titanium/nitride.

9. Process according to one of Claims 6 to 8, characterized in that the covering layers (9, 19), comprising a metal silicide, preferably molybdenum silicide, and the nucleation layers (7, 17, 27), comprising titanium/titanium nitride, are created by cathode sputtering.

10. Process according to one of Claims 6 to 9, characterized in that the metallization levels (8, 18, 28) comprise aluminium or the compound aluminium/silicon, aluminium/copper, aluminium/copper/silicon or aluminium/titanium and are created by cathode sputtering or vapour deposition.

11. Process according to one of Claims 6 to 10, characterized in that the covering layers (9, 19) comprise molybdenum silicide and in that the following layer thicknesses are established for the interlayers (5, 7, 17, 9, 19):
| | |
|---|---|
| Tungsten silicide layer (WSiₓ) | 5 to 30 nm, |
| Titanium layer (Ti) | 10 to 30 nm, |
| Titanium nitride layer (TiN) | 50 to 150 nm, |
| Molybdenum silicide layer (MoSi₂) | 100 nm. |

12. Process according to one of Claims 6 to 11, characterized in that the insulating layers (2, 10, 20) between the metallization levels (8, 18, 28) comprise SiOₓ and are produced by cathode sputtering.

13. Process according to one of Claims 6 to 12, characterized in that the process sequence is repeated as often as desired for a plurality of metallization levels (8, 18, 28).

## Revendications

1. Circuit intégré à semi-conducteurs ayant un substrat (1) en silicium, dans lequel et sur lequel les éléments formant le circuit sont fabriqués par une première couche d'isolation (2) appliquée sur le substrat et munie de trous de contact (3) et par au moins deux plans de métallisation (8,18,28) en aluminium ou en un composé d'aluminium, séparés par une autre couche d'isolation (10,20) munie de trous de contact (13), et reliés entre eux et avec les zones (4) à contacter dans et sur le substrat en silicium (1) au moyen de garnissages (6,16,26) de trous de contact en tungstène, une couche intermédiaire (9,19) en siliciure de métal étant appliquée sur chaque plan de métallisation (8,18,28) comme couche de finition caractérisé par
a) une première couche intermédiaire (5) métallique en siliciure de tungstène (WSiₓ) ou en titane/tungstène, en titane-nitrure de tungstène ou en nitrure de titane, interposée entre les garnissages (6) les plus bas de trous de contact et les zones de substrat (4) à mettre en contact et
b) une couche intermédiaire (7,17,27) servant de couche de germination pour la métallisation par l'aluminium, disposée respectivement sous un plan de métallisation, la couche intermédiaire (7,17,29) étant constituée d'une double couche Ti/TiN de texture définie, de sorte que le plan de métallisation par l'aluminium (8,18,28) situé au-dessus présente pour augmenter la résistance à la migration des électrons une importante texture 〈III〉 ayant une répartition homogène de la dimension des cristallites.

2. Circuit intégré à semi-conducteurs suivant la revendication 1, caractérisé en ce que la couche intermédiaire (7,17,27) est constituée d'une couche de titane d'une épaisseur de 10 à 30 nm et d'une couche de nitrure de titane d'une épaisseur de 50 à 150 nm.

3. Circuit intégré à semi-conducteurs suivant la revendication 1 ou 2, caractérisé en ce que les couches de finition (9,19) sont en siliciure de molybdène (MoSi₂).

4. Circuit intégré à semi-conducteurs suivant la revendication 3, caractérisé en ce que les couches de siliciure de molybdène (9,19) ont une épaisseur de 50 à 200 nm.

5. Circuit intégré à semi-conducteurs suivant l'une des revendications 1 à 4, caractérisé en ce que l'épaisseur des premières couches intermédiaires (5) en siliciure de tungstène (WSiₓ) ou en titane/tungstène, titane/nitrure de tungstène ou en nitrure de titane, et va de 5 à 30 nm.

6. Procédé de fabrication d'un circuit intégré à semi-conducteurs ayant un système multicouche comportant au moins deux plans de métallisation suivant l'une des revendications 1 à 5, qui comprend les étapes suivantes:
a) application sur toute la surface du substrat de semi-conducteurs (1) muni des trous de contact (3) dans la première couche d'isolation (2) d'une première couche inetrmédiaire (5) en siliciure de tungstène ou un composé de titane/tungstène, en nitrure de tungstène/titane ou en nitrure de titane servant de couche de germination et de couche-barrière et remplissage des trous de contact (3) avec du tungstène (6) par dépôt chimique en phase vapeur sous pression réduite (LPCVD) ;
b) élimination de la couche de tungstène/siliciure de tungstène sur les surfaces horizontales du substrat (1) jusqu'à ce que seuls les trous de contact (3) soient
c) dépôt sur toute la surface, tout d'abord d'une couche de titane, puis d'une couche de nitrure de titane par métallisation sous vide et/ou par pulvérisation cathodique en tant que couche de germination (7) ;
d) apport du premier plan de métallisation (8) en aluminium ou en un composé d'aluminium par métallisation sous vide ou par pulvérisation cathodique ;
e) apport d'une couche de finition (9) constituée d'un siliciure de métal sur le premier plan de métallisation (8) par pulvérisation cathodique ;
f) structuration du premier plan de métallisation (8) par la couche de finition (9) en siliciure de métal et la couche de germination (7) en titane/nitrure de titane ;
g) dépôt de la deuxième couche d'isolation (10) et aménagement de trous de contact (13) (via holes) dans celle-ci ;
h) remplissage des trous de contact (13) par du tungstène par précipitation sélective de tungstène en la phase gazeuse en utilisant de l'hexafluorure de tungstène ;
i) dépôt d'une autre combinaison de couche (17) de titane/nitrure de titane comme au stade c) ; et
j) production du deuxième plan de métallisation (18) en aluminium ou en un composé d'aluminium, et de la couche de finition (19) en un siliciure de métal comme aux stades d) et e).

7. Procédé suivant la revendication 6, caractérisé en ce que, au lieu des stades a) et b), la couche de tungstène/siliciure de tungstène (5,6) est déposée par dépôt sélectif en phase gazeuse dans le trou de contact (3).

8. Procédé suivant la revendication 6, caractérisé en ce que la première couche intermédiaire (5) dans le trou de contact est formée par dépôt en phase gazeuse pour le siliciure de tungstène ou par dépôt par pulvérisation cathodique pour le titane/tungstène, pour le titane/nitrure de tungstène ou pour le nitrure de titane. de tungstène ou pour le nitrure de titane.

9. Procédé suivant l'une des revendications 6 à 8, caractérisé en ce que les couches de finition (9,19) en un siliciure de métal, de préférence en siliciure de molybdène, et les couches de germination (7,17,27) en titane/nitrure de titane, sont produites par pulvérisation cathodique.

10. Procédé suivant l'une des revendications 6 à 9, caractérisé en ce que les plans de métallisation (8,18,28) sont en aluminium ou en un composé aluminium/silicium, aluminium/cuivre, aluminium/cuivre/silicium ou aluminium/titane et sont produits par pulvérisation cathodique ou par métallisation sous vide.

11. Procédé suivant l'une des revendications 6 à 10, caractérisé en ce que les couches de finition (9,19) sont en siliciure de molybdène, et que pour les couches intermédiaires (5,7,17,9,19) on règle les épaisseurs de couches suivantes:
| | |
|---|---|
| couche de siliciure de tungstène (WSiₓ) | 5 à 30 nm |
| couche de titane (Ti) | 10 à 30 nm |
| couche de nitrure de titane (TiN) | 50 à 150 nm |
| couche de siliciure de molybdène (MoSi₂) | 100 nm |

12. Procédé suivant l'une des revendications 6 à 11, caractérisé en ce que les couches d'isolation (2,10,20) entre les plans de métallisation (8,18,28) sont en SiOₓ et sont produites par pulvérisation cathodique.

13. Procédé suivant l'une des revendications 6 à 12, caractérisé en ce que la suite des opérations est répétée à volonté pour plusieurs plans de métallisation (8,18,28).
